# FASCICULE DE BREVET EUROPEEN

(11) **EP 1 760 738 B1**
(45) Date de publication et mention de la délivrance du brevet: **19.10.2011**
(21) Numéro de dépôt: 06119100.3
(22) Date de dépôt: 17.08.2006
(51) Int. Cl.: H01H 3/02

(54) **Bouton de commande à détection de présence**
Bedienungsknopf mit Präsenzerfassung
Control knob with presence detection

(30) Priorité: 02.09.2005 FR 0509027
(43) Date de publication de la demande: 07.03.2007
(73) Titulaire: Valeo Systèmes Thermiques, 78321 Le Mesnil St Denis Cedex (FR)
(72) Inventeur: Le Gallic, Lan, 93370, Montfermeil 93370 (FR)
(74) Mandataire: Croonenbroek, Thomas Jakob

(56) Documents cités:
- DE-A1- 3 910 977
- US-A- 5 541 622
- US-A- 6 040 821

## Description

L'invention concerne un bouton de commande. Elle concerne plus particulièrement un bouton de commande comprenant une partie mobile susceptible d'être actionnée manuellement et couplée à un transducteur électromécanique.

De nombreux boutons de ce type sont connus. On citera par exemple les boutons-poussoirs, les boutons rotatifs, etc. On comprend que la forme de la partie mobile peut être très différente selon les modèles. Cette forme peut notamment prendre en compte des critères ergonomiques.

Dans les boutons du type cité en introduction, le transducteur convertit le mouvement mécanique produit sur la partie mobile par un utilisateur en signaux électriques pouvant servir à une commande.

Néanmoins de tels dispositifs doivent être identifiés pour que l'utilisateur connaisse l'action commandée par un bouton particulier.

Le plus souvent, cette identification est réalisée par apposition d'une légende textuelle ou graphique sur le bouton, ou à proximité de celui-ci.

Dans certains cas, on souhaite que les boutons puisent être actionnés à l'aveugle, c'est-à-dire sans nécessité pour l'utilisateur de visualiser directement le bouton à actionner. Il reste nécessaire d'identifier les boutons.

Les boutons précités ne peuvent pas être employés, car ils ne peuvent pas être identifiés à l'aveugle.

Le document "US-A-5 541 622" décrit un bouton de commande selon le préambule de la revendication 1.

C'est pourquoi, la présente invention propose un bouton de commande du type défini en introduction qui comprend en outre une surface métallique agencée à proximité de la partie mobile et des moyens de mesure de la capacité de la surface métallique en sorte qu'une présence d'un doigt sur la partie mobile peut être détectée.

Dès lors, il est possible de faire parvenir à l'utilisateur une information stipulant que son doigt est disposé sur un bouton particulier et qu'il s'apprête à l'actionner. On peut intégrer à cette information une information identifiant le bouton. L'utilisateur peut ainsi actionner ledit bouton à l'aveugle.

De préférence, les moyens de mesure de capacité sont aptes à détecter une variation de la capacité de la surface métallique.

Dans un premier mode de réalisation, le transducteur électromécanique comprend un commutateur de type poussoir actionné par translation de la partie mobile.

Dans un second mode de réalisation, le transducteur électromécanique comprend un composant de type encodeur incrémental rotatif actionné par rotation de la partie mobile.

Dans le premier mode de réalisation, la surface métallique est avantageusement mobile en translation par rapport aux moyens de mesure de capacité.

La surface métallique est alors avantageusement reliée aux moyens de mesure de capacité par l'intermédiaire d'un ressort en sorte que la surface métallique et les moyens de mesure de capacité sont maintenus en contact électrique lors d'une translation de la partie mobile.

Les moyens de mesure de capacité peuvent être montés sur une platine.

En variante, les moyens de mesure de capacité sont montés sur un circuit imprimé.

Dans tous les cas, il est avantageux que la surface métallique coopère avec la partie mobile par complémentarité de forme.

Dans un mode de réalisation avantageux, la surface métallique est portée par une coupelle.

Dans ce cas, la coupelle présente avantageusement une jonction métallisée reliée à la surface métallique de manière à relier la surface métallique aux moyens de mesure de capacité.

Dans un mode de réalisation particulièrement avantageux, la surface métallique est réalisée sous forme de lame métallique.

L'invention concerne également un dispositif de commande comprenant un ou plusieurs boutons de ce type.

Dans un mode de réalisation particulier, le dispositif comprend un micro-contrôleur relié aux moyens de mesure de capacité par l'intermédiaire d'une première interface et au transducteur par l'intermédiaire d'une seconde interface. D'autres caractéristiques et avantages de l'invention apparaîtront à l'examen de la description détaillée ci-après et des dessins annexés sur lesquels :
- la figure 1 est une vue en coupe d'un bouton de commande selon l'invention dans un premier mode de réalisation,
- la figure 2 est une vue en perspective du bouton de commande de la figure 1,
- la figure 3 est une vue en coupe d'un bouton de commande selon l'invention dans un second mode de réalisation,
- la figure 4 est une vue en perspective du bouton de commande de la figure 3,
- la figure 5 est un schéma fonctionnel d'un dispositif de commande comprenant au moins un bouton de commande selon le premier mode de réalisation, et
- la figure 6 est un schéma fonctionnel d'un dispositif de commande comprenant au moins un bouton de commande selon le deuxième mode de réalisation.

Les dessins annexés pourront non seulement servir à compléter l'invention, mais aussi contribuer à sa définition, le cas échéant.

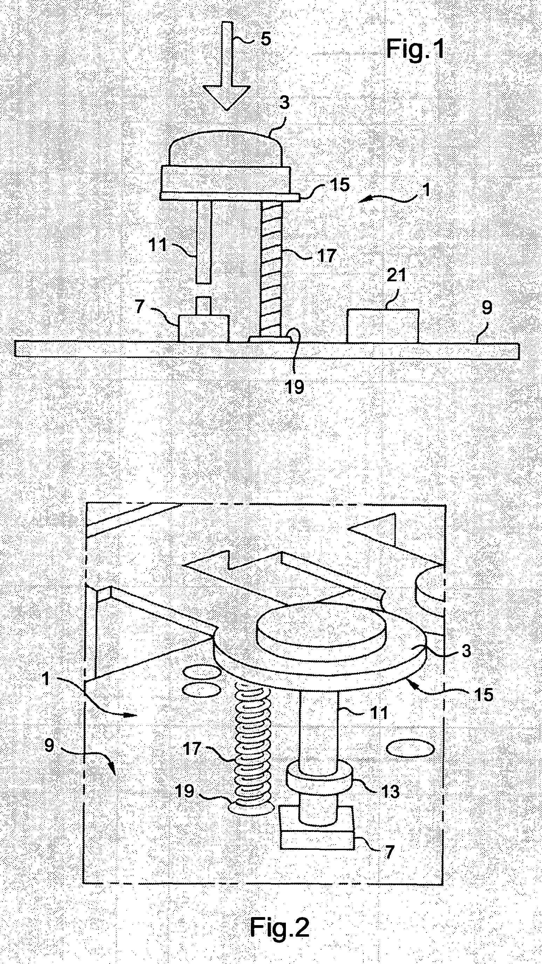

Les figures 1 et 2 illustrent un premier mode de réalisation de l'invention. Le bouton-poussoir 1 des figures 1 et 2 comprend une partie mobile 3, ou corps de bouton, susceptible d'être actionnée manuellement, par exemple par pression d'un doigt. La partie mobile 3 comprend alors avantageusement une surface supérieure incurvée de manière à conférer une bonne ergonomie à la partie mobile 3, comme illustré sur la figure 2.

La partie mobile 3 est apte à se déplacer en translation selon une direction sensiblement verticale, symbolisée sur la figure 1 par la flèche 5. Le terme "vertical" se rapporte ici à la disposition du bouton-poussoir 1 sur les figures 1 et 2 et ne présage aucunement de la position de ce bouton-poussoir 1 une fois intégré, par exemple à un dispositif de commande.

Le bouton-poussoir 1 comprend en outre un commutateur 7 de type "poussoir" monté sur une platine 9. Le commutateur 7 est agencé au droit de la partie mobile 3 de sorte que le déplacement en translation de la partie mobile 3 provoque l'actionnement du commutateur 7.

Ici, une tige 11 solidaire de la partie mobile 3 est intercalée entre le commutateur 7 et cette partie mobile 3. La tige 11 transmet les efforts entre la partie mobile 3 et le commutateur 7. La tige 11 est optionnelle : elle peut être supprimée lorsque le commutateur 7 est rehaussé par rapport à la platine 9.

La tige 11 peut se terminer par une surface d'appui 13 élargie (figure 2) pour faciliter l'actionnement du commutateur 7.

Le bouton-poussoir 1 comprend en outre une surface métallique réalisée ici sous la forme d'une lame métallique 15 solidaire de la partie mobile 3. Ici, cette lame 15 est agencée sur une surface inférieure de la partie mobile 3. Un ressort de compression 17 réalisé en un matériau électriquement conducteur s'appuie sur la lame 15 et sur une pastille métallique 19 montée sur la platine 9. La lame 15 et la pastille 19 sont de préférence réalisées en cuivre ou alliage de cuivre. Cependant, tout matériau électriquement conducteur peut être employé. Le ressort 17 est disposé de manière à travailler selon la direction de translation de la partie mobile 3 indiquée par la flèche 5. Ici, le ressort est disposé sensiblement verticalement.

Grâce au ressort 17, la lame 15 et la pastille 19 sont en contact électrique permanent même lors d'un déplacement de la partie mobile 3.

Dans d'autres modes de réalisation, une tige supplémentaire (non représentée) peut être insérée à l'intérieur du ressort 17 pour garantir un maintien vertical et un guidage lors d'une compression du ressort 17.

La pastille métallique 19 est reliée à des moyens de mesure de capacité. Ces moyens de mesure sont aptes à détecter et à réagir à une variation de la capacité de la lame 15. Une telle variation est par exemple provoquée par la présence d'un doigt sur la partie mobile 3. Ici, les moyens de mesure de capacité sont réalisés sous la forme d'un circuit imprimé (non représenté) supporté par la platine 9. Le circuit imprimé peut inclure la platine 9 ou être rapportée sur celle-ci.

Une interface de traitement 21 est reliée à la pastille 19, par exemple par une liaison de type filaire. Ainsi, les moyens de mesure de capacité sont aptes à réagir à une variation de la capacité de la lame 15 en transmettant à l'interface de traitement 21 un signal de détection. Une telle variation de la capacité survient par exemple lorsqu'un doigt est posé sur la partie mobile 25.

Ici, l'interface de traitement 21 est montée sur la platine 9. Il s'entend que l'interface de traitement 21 peut être disposée en des endroits différents. D'autres types de liaison peuvent être prévus entre la pastille 19 et l'interface de traitement 21, par exemple une portion de circuit imprimé.

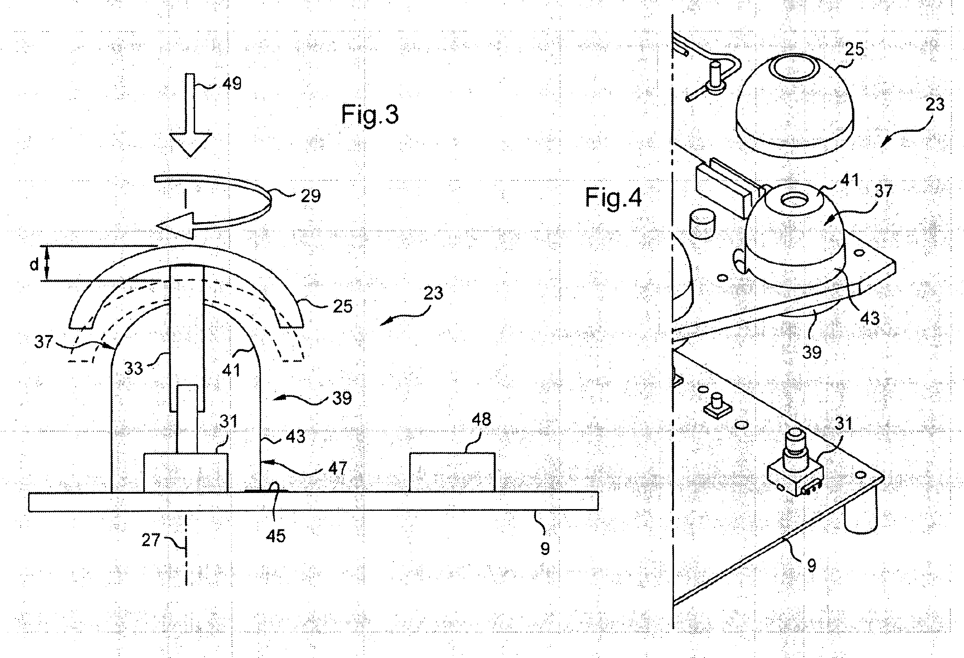

Les figures 3 et 4 illustrent un second mode de réalisation de l'invention. Le bouton rotatif 23 des figures 3 et 4 comprend une partie mobile 25 capable de tourner autour d'un axe 27 vertical comme symbolisé par la flèche courbe 29.

La partie mobile 25 est ici réalisée sous la forme d'une coupelle ou coque fine. Préférentiellement, cette coupelle présente une forme sensiblement hémisphérique. Ici, elle est réalisée en matière plastique. D'autres matériaux sont néanmoins envisageables.

Le bouton rotatif 23 comprend un transducteur électromécanique sous la forme d'un encodeur incrémental 31 couplé à la partie mobile 25. L'encodeur incrémental 31 est capable de réagir à un mouvement de rotation de la partie mobile 25 par l'émission de signaux électriques.

Ici, une tige 33 couple de manière solidaire en rotation l'encodeur 31 et la partie mobile 25. Ici, la tige 33 fait partie intégrante de la partie mobile 25.

Une platine 9 analogue à la platine 9 des figures 1 et 2 supporte l'encodeur 31. Une surface métallique réalisée ici sous forme de coupelle métallique 37 est agencée à proximité de la partie mobile 25. Ici, la coupelle 37 est de forme complémentaire à la forme de la partie mobile 25 et est disposée en dessous de celle-ci. Dans ce mode de réalisation, la coupelle 37 est de forme sensiblement hémisphérique.

La coupelle 37 est portée par une coupelle 39 ou coque fine présentant une surface hémisphérique 41 analogue à la coupelle 37. La coupelle 39 est prolongée par une partie cylindrique 43 s'appuyant sur la platine 35. La coupelle métallique 37 peut être réalisée par dépôt métallique, ou métallisation, sur la coupelle 39.

La coupelle métallique 37 est reliée à des moyens de mesure de capacité. Ces moyens de mesure sont aptes à détecter et à réagir à une modification de la capacité de la coupelle métallique 37. Ici, les moyens de mesure de capacité sont réalisés sous forme de circuit imprimé (non représenté) porté par la platine 9. Le circuit imprimé peut inclure la platine 9 ou être rapporté sur celle-ci. En particulier, une pastille métallique 45 reliée au circuit imprimé est disposée au droit de la coupelle 39. La pastille 9 est de préférence réalisée en cuivre ou en alliage de cuivre. Tout matériau électriquement conducteur peut être employé. La surface extérieure de la coupelle 39 présente une jonction métallisée 47 courant de la coupelle 37 à la pastille métallique 45 en reliant ces dernières électriquement. De la même manière, la jonction métallisée 47 peut être prévue sur la surface intérieure de la coupelle 39.

Une interface de traitement 48 est reliée à la pastille 45, par exemple par une liaison filaire. Ainsi, les moyens de mesure de capacité sont aptes à réagir à une variation de la capacité de la surface métallique 37 par la transmission d'un signal de détection à l'interface de traitement 48. Une telle variation de la capacité survient par exemple lorsqu'un doigt est posé sur la partie mobile 25.

Ici, l'interface de traitement 48 est montée sur la platine 9. Il s'entend que l'interface de traitement 48 peut être disposée en des endroits différents. D'autres types de liaison peuvent être prévus entre la pastille 45 et l'interface de traitement 48, par exemple une portion de circuit imprimé.

Bien qu'une lame d'air soit immanquablement présente entre la partie mobile 25 et la coupelle 37, celle-ci n'influe que très légèrement sur la mesure de la capacité réalisée par les moyens de mesure de capacité. Cette lame d'air ne nuit pas par exemple à la détection de la présence d'un doigt sur la partie mobile 25.

Optionnellement, la partie mobile 25 est en outre capable de translation suivant l'axe 27. Cette translation est symbolisée par la flèche 49 de la figure 3 et par la représentation en pointillée de la partie mobile 25. Le transducteur électromécanique comprend alors en outre une fonction commutateur de type "bouton-poussoir" comme décrit sur les figures 1 et 2. Ici, la fonction poussoir est intégrée à l'encodeur 31.

Dans ce mode de réalisation, on veille à ménager entre la surface métallique 37 et la partie mobile 25 une distance d suffisante pour la course de la fonction bouton-poussoir.

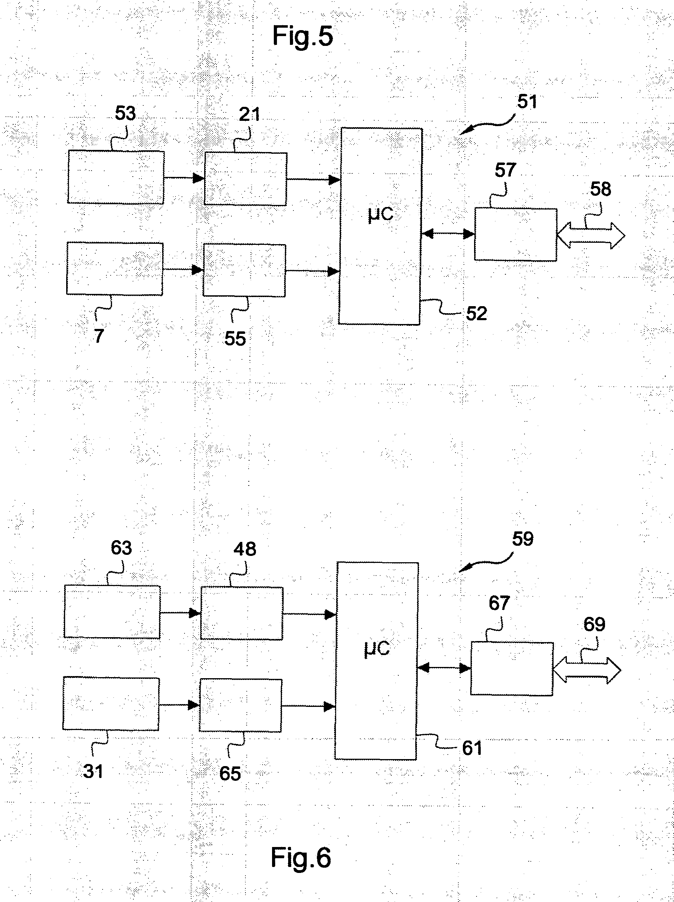

La figure 5 illustre fonctionnellement un dispositif de commande 51 mettant en oeuvre le bouton-poussoir 1 des figures 1 et 2. Le dispositif 51 comprend un micro-contrôleur 52 relié par l'intermédiaire de l'interface de traitement 21 aux moyens de mesure de capacité 53.

Le micro-contrôleur est en outre relié au commutateur 7 par l'intermédiaire d'une interface de traitement supplémentaire 55 apte à réagir à l'actionnement du commutateur 7.

Le dispositif de commande 51 permet la détection de la présence d'un doigt sur le bouton-poussoir 1 et la détection de l'actionnement du commutateur 7. Par exemple, le dispositif 51 peut être couplé à des appareils à commander par une interface 57 et un réseau de communication 58.

Le dispositif 51 peut être couplé à un organe d'affichage pour présenter un bouton-poussoir sur lequel un doigt est posé avant actionnement du commutateur 7 associé à ce bouton-poussoir. Ceci présente un intérêt dans les cas où il est préférable que l'attention d'un utilisateur soit focalisée sur un écran plutôt que sur les boutons-poussoir à actionner.

La figure 6 illustre fonctionnellement un organe de commande 59. Le dispositif de commande 59 comprend un micro-contrôleur 61 relié aux moyens de mesure de capacité 63 par l'intermédiaire de l'interface de traitement 48. Le micro-contrôleur est relié à l'encodeur 31 par une interface supplémentaire 65.

Le dispositif de commande 59 permet la détection de présence d'un doigt sur la partie mobile 25, la détection d'un angle de rotation de la partie mobile 25 et éventuellement la détection de l'actionnement d'un commutateur lorsque la partie mobile 25 est en outre capable de translation verticale.

Le dispositif de commande 59 peut être couplé par une interface 67 et un réseau de communication 69 à des appareils à commander.

Le dispositif 59 peut être complété ou combiné à une interface graphique affichant par exemple une représentation d'une fonction pouvant être réglée en tournant/actionnant le bouton rotatif 23. Cette représentation peut être mise en évidence lorsque la présence d'un doigt est détectée.

Le bouton-poussoir 1 et/ou le bouton rotatif 23 couplés aux dispositifs de commande 51 et/ou 59 peuvent être intégrés dans un organe de commande pour centrale de commande d'appareils de bord, par exemple pour un véhicule automobile. Une telle centrale peut comprendre un organe d'affichage représentant la disposition des boutons 1 et/ou 23 sur l'organe de commande ainsi que l'action associée aux boutons 1 et/ou 23. De préférence, la représentation d'un bouton 1 et/ou 23 est mise en évidence lorsque le doigt d'un utilisateur est détecté. Ainsi l'utilisateur est informé, sans même regarder le bouton, sur l'action qu'il s'apprête à commander. Avantageusement, l'organe d'affichage est disposé dans un véhicule automobile de manière que le conducteur puisse le voir sans détourner son attention de la route. Les appareils commandés peuvent être du type dispositif de chauffage, de ventilation et/ou d'air conditionné, dispositif de lecture de support musical, récepteur radio, dispositif de guidage par satellite ou tout autre dispositif pouvant être intégré dans un véhicule automobile.

D'autres modes de réalisation peuvent découler de ceux décrits plus haut. Les moyens de détection de présence d'un doigt pourraient également être prévus sur des boutons coulissants ou sur des leviers.

En outre, les dispositifs 51 et 59 peuvent être combinés de manière à réaliser un organe de commande complexe. En particulier, il s'entend que dans la pratique, les dispositifs 51 et 61 comprennent en général plusieurs boutons-poussoirs 1 et/ou boutons rotatifs 23.

L'invention trouve une application toute particulière dans des dispositifs de commande à actionner "en aveugle" et dont les actions sont représentées sur des afficheurs.

## Revendications

1. Bouton de commande comprenant une partie mobile (25) susceptible d'être actionnée manuellement et couplée à un transducteur électromécanique (31), ledit bouton de commande comprenant en outre une surface métallique (37) agencée à proximité de la partie mobile (25) et des moyens de mesure de la capacité (63) de la surface métallique (37), **caractérisé en ce que** la surface métallique(37) est portée par une coupelle (39), ladite coupelle (39) présentant une jonction métallisée (47) reliée à la surface métallique de manière à relier ladite surface métallique (37) aux moyens de mesure de capacité (63).

2. Bouton de commande selon la revendication 1, **caractérisé en ce que** les moyens de mesure de capacité (63) sont aptes à détecter une variation de la capacité de la surface métallique ( 37).

3. Bouton de commande selon l'une des revendications 1 et 2, **caractérisé en ce que** le transducteur électromécanique (31) comprend un commutateur (31) de type poussoir actionné par translation de la partie mobile (25).

4. Bouton de commande selon l'une des revendications précédentes, **caractérisé en ce que** le transducteur électromécanique (31) comprend un composant de type encodeur incrémental rotatif (31) actionné par rotation de la partie mobile (25).

5. Bouton de commande selon l'une des revendications précédentes, **caractérisé en ce que** les moyens de mesure de capacité (63) sont montés sur une platine (9).

6. Bouton de commande selon l'une des revendications précédentes, **caractérisé en ce que** lesdits moyens de mesure sont montés sur un circuit imprimé.

7. Bouton de commande selon l'une des revendications précédentes, **caractérisé en ce que** la surface métallique (37) coopère avec la partie mobile (25) par complémentarité de forme.

8. Bouton de commande selon l'une des revendications précédentes, **caractérisé en ce que** la surface métallique est réalisée sous forme de lame métallique.

9. Dispositif de commande comprenant au moins un bouton de commande selon la revendication 1.

10. Dispositif selon la revendication 9, **caractérisé en ce qu'**il comprend en outre un micro-contrôleur (61) relié aux moyens de mesure de capacité (63) par l'intermédiaire d'une première interface (47) et au transducteur (31) par l'intermédiaire d'une seconde interface (65).

## Claims

1. Control knob comprising a movable portion (25) capable of being actuated manually and coupled to an electromechanical transducer (31), the said control knob also comprising a metallic surface (37) arranged close to the movable portion (25) and means (63) for measuring the capacitance of the metallic surface (37), **characterized in that** the metallic surface (37) is supported by a dish (39), the said dish (39) having a metallized junction (47) connected to the metallic surface so as to connect the said metallic surface (37) to the means (63) for measuring capacitance.

2. Control knob according to Claim 1, **characterized in that** the means (63) for measuring capacitance are capable of detecting a variation in the capacitance of the metallic surface (37).

3. Control knob according to one of Claims 1 and 2, **characterized in that** the electromechanical transducer (31) comprises a switch (31) of the button type actuated by translation of the movable portion (25).

4. Control knob according to one of the preceding claims, **characterized in that** the electromechanical transducer (31) comprises a component of the rotary incremental encoder type (31) actuated by rotation of the movable portion (25).

5. Control knob according to one of the preceding claims, **characterized in that** the means (63) for measuring capacitance are mounted on a plate (9).

6. Control knob according to one of the preceding claims, **characterized in that** the said measurement means are mounted on a printed circuit.

7. Control knob according to one of the preceding claims, **characterized in that** the metallic surface (37) interacts with the movable portion (25) by complementarity of shape.

8. Control knob according to one of the preceding claims, **characterized in that** the metallic surface is made in the form of metallic strip.

9. Control device comprising at least one control knob according to Claim 1.

10. Device according to Claim 9, **characterized in that** it also comprises a microcontroller (61) connected to the means (63) for measuring capacitance by means of a first interface (47) and to the transducer (31) by means of a second interface (65) .

## Patentansprüche

1. Steuerknopf, der einen beweglichen Teil (25) umfasst, der manuell betätigt und mit einem elektromechanischen Wandler (31) gekoppelt werden kann, wobei der Steuerknopf außerdem eine metallische Oberfläche (37), die in der Nähe des beweglichen Teils (25) angeordnet ist, und Mittel (63) zum Messen der Kapazität der metallischen Oberfläche (37) umfasst, **dadurch gekennzeichnet, dass** die metallische Oberfläche (37) von einer Schale (39) getragen wird, wobei die Schale (39) einen metallisierten Übergang (47) aufweist, der mit der metallischen Oberfläche in der Weise verbunden ist, dass die metallische Oberfläche (37) mit den Kapazitätsmessmitteln (63) verbunden ist.

2. Steuerknopf nach Anspruch 1, **dadurch gekennzeichnet, dass** die Kapazitätsmessmittel (63) eine Veränderung der Kapazität der metallischen oberfläche (37) detektieren können.

3. Steuerknopf nach einem der Ansprüche 1 und 2, **dadurch gekennzeichnet, dass** der elektromechanische Wandler (31) einen Umschalter (31) des Drückertyps umfasst, der durch translatorische Bewegung des beweglichen Teils (25) betätigt wird.

4. Steuerknopf nach einem der vorhergehenden Ansprüche, **dadurch gekennzeichnet, dass** der elektromechanische Wandler (31) eine Komponente (31) des Typs rotierender inkrementaler Codierer umfasst, der durch Drehen des beweglichen Teils (25) betätigt wird.

5. Steuerknopf nach einem der vorhergehenden Ansprüche, **dadurch gekennzeichnet, dass** die Kapazitätsmessmittel (63) an einer Platine (9) montiert sind.

6. Steuerknopf nach einem der vorhergehenden Ansprüche, **dadurch gekennzeichnet, dass** diese Messmittel an einer gedruckten Schaltung montiert sind.

7. Steuerknopf nach einem der vorhergehenden Ansprüche, **dadurch gekennzeichnet, dass** die metallische Oberfläche (37) mit dem beweglichen Teil (25) durch Formkomplementarität zusammenwirkt.

8. Steuerknopf nach einem der vorhergehenden Ansprüche, **dadurch gekennzeichnet, dass** die metallische Oberfläche in Form eines metallischen Plättchens verwirklicht ist.

9. Steuervorrichtung, die wenigstens einen Steuerknopf nach Anspruch 1 umfasst.

10. Vorrichtung nach Anspruch 9, **dadurch gekennzeichnet, dass** sie außerdem einen Mikrocontroller (61) umfasst, der mit den Kapazitätsmessmitteln (63) über eine erste Schnittstelle (47) und mit dem Wandler (31) über eine zweite Schnittstelle (65) verbunden ist.
